# EUROPEAN PATENT SPECIFICATION

(11) **EP 2 713 199 B1**
(45) Date of publication and mention of the grant of the patent: **10.01.2018**
(21) Application number: 13180101.1
(22) Date of filing: 12.08.2013
(51) Int. Cl.: G02F 1/1335, G02B 5/22, G03F 7/00

(54) **Color filter substrate and fabrication method thereof, transflective liquid crystal display device**
Farbfiltersubstrat und Herstellungsverfahren dafür, transflektive Flüssigkristallanzeigevorrichtung
Substrat de filtre coloré et son procédé de fabrication, dispositif d'affichage à cristaux liquides transflectif

(30) Priority: 27.09.2012 CN 201210365824
(43) Date of publication of application: 02.04.2014
(73) Proprietor: BOE Technology Group Co., Ltd., Beijing 100015 (CN)
(72) Inventor: Qi, Yonglian, Beijing 100176 (CN); Wang, Can, Beijing 100176 (CN); Hui, Guanbao, Beijing 100176 (CN); Xue, Jianshe, Beijing 100176 (CN)
(74) Representative: Brötz, Helmut

(56) References cited:
- JP-A- 2001 221 910
- US-A1- 2005 057 711
- US-A1- 2007 008 466

## Description

### TECHNICAL FIELD

Embodiments of the present invention relate to a color filter substrate and a fabrication method thereof, and a transflective liquid crystal display device comprising the color filter substrate.

### BACKGROUND

As liquid crystal display is a non-self-luminous display, the liquid crystal display panel must be provided with a light source such as backlight, front light or external light source in order to display images. In accordance with different ways of using the light source, the liquid crystal display is divided into three kinds of transmissive liquid crystal display, reflective liquid crystal display and transflective liquid crystal display. Currently, the transflective liquid crystal display gets more concern as it can simultaneously use light from the external light source and the backlight, which is helpful for application in portable products.

The normal transflective liquid crystal display includes a color filter substrate, and a color filter layer is provided on the color filter substrate. The transflective liquid crystal display includes a transmissive region and a reflective region, wherein the reflective region has a reflecting electrode or a reflecting layer for reflecting light from the external light source. The light from outside is incident on the reflecting electrode or reflecting layer through the color filter layer, and the light reflected by the reflecting electrode or reflecting layer returns to outside through the color filter layer, that is, the light runs through the color filter layer twice. In contrast, the light in the transmissive region is emitted from the backlight and runs through the color filter layer only once. Therefore, colors displayed in the reflective region and the transmissive region of the transflective liquid crystal display device may be incongruous.

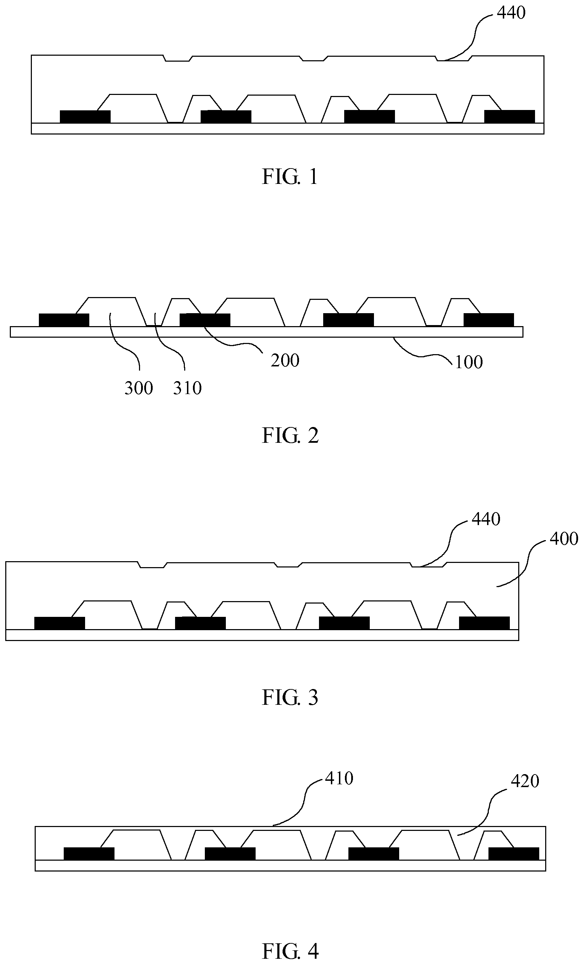

To solve the problem decribed above, an aperture may be provided in the color filter pattern corresponding to the reflective region in the color filter layer. The light from outside is incident into the reflective region via the aperture, and the reflecting electrode or reflecting layer disposed in the reflective region has a diffuse reflection effect. The light underwent the diffuse reflection by the reflecting electrode or reflecting layer is incident on the color filter pattern around the aperture, so in the reflective region, the incident light runs through the color filter layer only once and then is emitted to outside. Thereby, the problem that colors displayed in the reflective region and the transmissive region are incongruous can be alleviated. In addition, the process of providing the aperture in the color filter pattern corresponding to the reflective region in the color filter layer is easy and simple. However, after coating a flat protective layer on the color filter layer, the aperture becomes a pit 440, as shown in FIG. 1. In order to reduce the depth of the pit, the conventional method is to increase the thickness of the flat protective layer. Within a certain range, the depth of the pit decreases as the thickness of the flat protective layer increases. However, after the thickness of the flat protetive layer increases to a certain degree, the depth of the pit will not decrease along with the increase of the thickness of the flat protective layer. The presence of the pit causes the flat protective layer not able to be completely flat, so that the cell gap is uneven after the cell assembly process of the transflective liquid crystal display is performed, resulting in the issues of grayscale deflection, reduction of reflectivity of the reflective region and the like. US 2007/0008466A1 discloses a liquid crystal device, a method of manufacturing liquid crystal device and an electronic apparatus. The liquid crystal device includes display pixels which correspond to at least a color of white or non-coloring and one color different from the color of white or non-coloring, each of the display pixels corresponding to one color having a transmissive region and a reflective region, and each of the display pixels corresponding to the color of white or non-coloring having only a transmissive region, a substrate, a counter substrate which is disposed so as to be opposite to the substrate, colored layers which are provided in the display pixels of the substrate or the counter substrate corresponding to one color, cell-thickness-adjusting layers which are provided in the substrate or the counter substrate and included in the reflective region of each of the display pixels corresponding to one color and the transmissive region of each of the display pixels corresponding to the color of white or non-coloring, and a liquid crystal layer which is interposed between the substrate and the counter substrate, the thickness of the layer crystal layer that corresponds to the transmissive region of each of the display pixels corresponding to one color is larger than the thickness of the liquid crystal layer that corresponds to the reflective region of each of the display pixels corresponding to one color according to the thickness of the cell-thickness-adjusting layer.
JP 2001-221910A discloses a color filter and a method of producing the same. The color filter is produced in the following processes.; In a first process, after a color layer of a plurality of colors is formed into a specified pattern on a substrate, a multilayered dry film having a columnar projection forming layer formed by applying a photosetting resin composition on a transfer substrate and having a transparent protective layer forming layer formed by applying an alkali insoluble resin composition on the columnar projection forming layer is laminated to cover at least the color layer with the transparent protective layer forming layer in contact with the color layer. In a second process, the columnar projection forming layer is exposed in the transfer substrate side through a photomask having openings corresponding to the pattern of columnar projections to be formed. In a third process, the transfer substrate is removed and the columnar projection forming layer is developed. From US 2005/0057711 A1 it is known a bi-display mode liquid crystal display.

### SUMMARY

According to claim 1 a color filter substrate of a transflective liquid crystal display is provided which comprises: a transparent base substrate; a plurality of black matrixes formed on a surface of the transparent base substrate and separating the surface of the transparent base substrate into a plurality of color filter regions; a plurality of color filter patterns that arrange alternatively with the black matrixes, wherein each color filter pattern covers one color filter region; an aperture formed in the color filter pattern on at least one of the color filter regions within a reflective region of the transflective liquid crystal display; a protective layer disposed on the color filter pattern and the aperture, wherein an upper surface of a portion of the protective layer above the color filter pattern is even with an upper surface of a portion of the protective layer above the aperture, wherein the color filter substrate further comprises a columnar spacer disposed above the black matrix, wherein the color filter substrate is characterized in that the columnar spacer and the protective layer are integrally formed, an entire surface of the protective layer and facing the column spacer is an even surface except for a portion on which the columnar spacer is formed and the protective layer and the columnar spacer are made of a photoresist.

For example, an upper surface of the columnar spacer is higher than an upper surface of the protective layer.

According to claim 3 a fabrication method of a color filter substrate is provided which includes steps of:
forming a plurality of black matrixes on a surface of a transparent base substrate, wherein the black matrixes separate the surface of the transparent base substrate into a plurality of color filter regions;
forming a plurality of color filter patterns that arrange alternatively with the black matrixes, wherein each color filter pattern covers one color filter region;
forming an aperture in the color filter pattern on at least one of the color filter regions within a reflective region of the transflective liquid crystal display;
forming a photoresist layer covering the black matrixes, the color filter patterns and the aperture; and
performing exposing and developing processes on the photoresist layer through a dual-tone mask to form a flat protective layer disposed on the color filter pattern and the aperture,
wherein an upper surface of a portion of the flat protective layer above the color filter pattern is even with an upper surface of a portion of the flat protective layer above the aperture, wherein at the same time of performing exposing and developing processes on the photoresist layer through a dual-tone mask, a columnar spacer disposed above the black matrix is also formed and wherein the fabrication method is characterized in that the columnar spacer and the protective layer are integrally formed, an entire surface of the protective layer and facing the columnar spacer is an even surface except for a portion on which the columnar spacer is formed, the protective layer and the columnar spacer are made of a photoresist layer, and the photoresist over the black matrix is completely exposed with a complete exposure amount of A, an exposure amount for exposing the photoresist over the color filter pattern is H4/H3×A, and an exposure amount for exposing the photoresist over the aperture is (H2+H4)/H3×A, where H2 is a thickness of the color filter pattern, H3 is a thickness of the photoresist over the black matrix, H4 is a thickness of the portion of the protective layer above the color filter pattern, and H2+H4 is a thickness of the portion of the protective layer above the aperture.

For example, an upper surface of the columnar spacer is higher than an upper surface of the protective layer.

According to claim 6, a transflective liquid crystal display device is provided. The transflective liquid crystal display device comprises the color filter substrate according to claim 1.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.
FIG. 1 is a schematic diagram of pits present on a flat protective layer in a conventional color filter substrate;
FIG. 2 is a schematic diagram after forming a separator, a color filter pattern and an aperture in a fabrication method of a color filter substrate according to a first embodiment of the present invention;
FIG. 3 is a schematic diagram after forming a photoresist layer covering the separator, the color filter pattern and the aperture in the fabrication method of the color filter substrate according to the first embodiment of the present invention;
FIG. 4 is a schematic diagram of a color filter substrate comprising a flat protective layer after performing exposing and developing processes on the photoresist layer through a dual-tone mask in the fabrication method of the color filter substrate according to the embodiment of the present invention;
FIG. 5 is a partially enlarged view of the color filter substrate shown in FIG. 4.
FIG. 6 is a schematic diagram of a color filter substrate comprising a columnar spacer and a flat protective layer after performing exposing and developing processes on the photoresist layer through a dual-tone mask in the fabrication method of the color filter substrate according to the embodiment of the present invention.

### DETAILED DESCRIPTION

In order to make objects, technical details and advantages of the embodiments of the invention apparent, the technical solutions of the embodiment will be described in a clearly and completely understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

A first embodiment of the present invention provides a fabrication method of a color filter substrate. The method comprises steps of:

Forming a plurality of separators on a surface of a transparent base substrate, wherein the separators are used for separating the surface of the transparent base substrate into a plurality of color filter regions;

Forming a plurality of color filter patterns that arrange alternatively with the separators, wherein each color filter pattern covers one color filter region;

Forming an aperture in the color filter pattern on at least one of the color filter regions; at this time, as shown in FIG. 2, the separators 200, the color filter patterns 300 and the apertures 310 are formed on the transparent base substrate 100;

Forming a photoresist layer covering the separators, the color filter patterns and the aperture; at this time, as shown in FIG. 3, a pit 440 is formed on a portion of the photoresist layer 400 corresponding to the aperture;

Performing exposing and developing processes on the photoresist layer 400 through a dual-tone mask such as a gray-tone mask to form a flat protective layer; at this time, as shown in FIG. 4, the photoresist layer after the exposing and developing processes forms a flat protective layer. The flat protective layer includes a portion 410 located above the color filter pattern and a portion 420 located above the aperture. An upper surface of the portion 410 of the flat protective layer above the color filter pattern is even with an upper surface of the portion 420 of the flat protective layer above the aperture.

In the fabrication method of the color filter substrate according to the present embodiment, the flat protective layer is formed by performing exposing and developing processes on the photoresist layer, and the upper surface of the portion of the flat protective layer above the color filter pattern is even with the upper surface of the portion of the flat protective layer above the aperture, so that the problem that the flat protective layer of the conventional color filter substrate has pits is solved.

Further, at the same time of performing exposing and developing processes on the photoresist layer through a dual-tone mask such as a gray-tone mask, a columnar spacer 430 above the separator may also be formed, and an upper surface of the columnar spacer 430 is higher than an upper surface of the flat protective layer. In this way, the columnar spacer and flat protective layer can be obtained by one patterning process, and thus the conventional manufacturing process for the columnar spacer can be omitted.

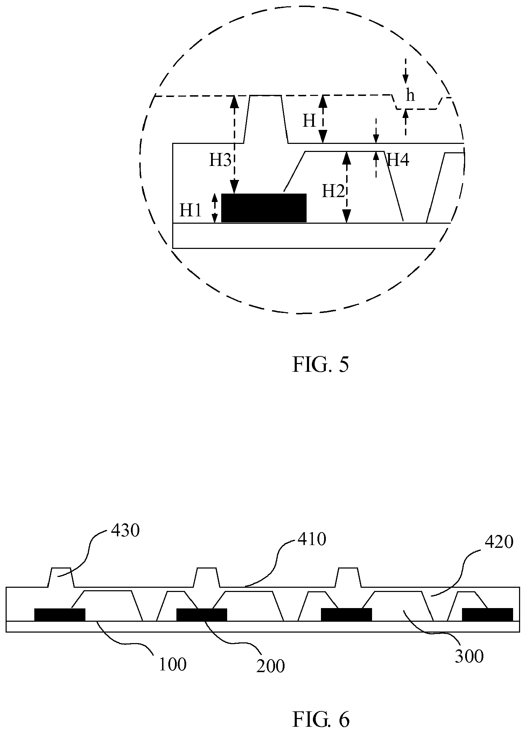

For example, the photoresist is a positive photoresist. The photoresist over the separator is completely exposed, an exposure amount for exposing the photoresist over the color filter pattern is equal to H4/H3×A, and an exposure amount for exposing the photoresist over the aperture is equal to (H2+H4)/H3×A, where A is an exposure amount of complete exposure. As shown in FIG. 5, H1 is a thickness of the separator, H2 is a thickness of the color filter pattern, H3 is a thickness of the photoresist over the separator, H4 is a thickness of the portion 410 of the flat protective layer above the color filter pattern, and H2+H4 is a thickness of the portion 420 of the flat protective layer above the aperture.

After the exposing and developing processes, the height of the removed photoresist over the color filter pattern H= H1+H3-(H2+H4), and H> h, where h is the depth of the pit. That is to say, the height of the removed photoresist over the color filter pattern is greater than the depth of the pit.

In the fabrication method of the color filter substrate according to the present embodiment, with a precise control of the exposure amount for exposing the photoresist over the color filter pattern and the exposure amount for exposing the photoresist over the aperture, the columnar spacer, the portion of the flat protective layer above the color filter pattern with the thickness of H4, and the portion of the flat protective layer above the aperture with the thickness of H2+H4 are obtained through one single patterning process. Thus, the pits in the flat protective layer of the conventional color filter substrate are eliminated. Meanwhile, the columnar spacer and the flat protective layer are obtained through one single patterning process, and thus the fabrication process for the color filter substrate can be simplified.

The separator may be a photoresist separator or a black matrix. However, the form of the separator is not limited to the types listed above, and the separator can adopt any other forms as long as it can separate the surface of the transparent base substrate into the plurality of color filter regions.

A specific example will be described below with reference to Fig. 5.

For example, the thickness of the separator is H1=1 µm, the thickness of the color filter pattern is H2=1.5 µm, the thickness of the photoresist over the separator is H3=4.5 µm, and the depth of the pit is h=0.5 µm.

For example, it is required the thickness of the portion 410 of the flat protective layer above the color filter pattern to be H4=1.5 µm, and the thickness of the portion 420 of the flat protective layer above the aperture to be H2+H4=1.5 µm + 1.5 µm = 3 µm.

The photoresist over the separator is completely exposed with an exposure amount of A, and all the photoresist over the separator with the thickness of 4.5 µm is used to form the columnar spacer.

The thickness of the portion 410 of the flat protective layer above the color filter pattern is H4=1.5 µm, that is, the portion 410 of the flat protective layer above the color filter pattern with the thickness of 1.5 µm is formed after the photoresist above the color filter pattern is exposed and developed. The exposure amount for exposing the photoresist above the color filter pattern is H4/H3×A=1.5/4.5×A=1/3×A.

The thickness of the portion 420 of the flat protective layer above the aperture is H2+H4=3 µm, that is, the portion 420 of the flat protective layer above the aperture with the thickness of 3 µm is formed after the photoresist above the aperture is exposed and developed. The exposure amount for exposing the photoresist above the aperture is (H2+H4)/H3 xA=3/4.5 xA=2/3 xA.

A second embodiment of the present invention provides a color filter substrate. The color filter substrate is obtained by the fabrication method according to the first embodiment.

As shown in FIG. 6, the color filter substrate comprises: a transparent base substrate 100; a plurality of separators 200 formed on a surface of the transparent base substrate and separating the surface of the transparent base substrate into a plurality of color filter regions; a plurality of color filter patterns 300 that arrange alternatively with the separators 200, wherein each color filter pattern covers one color filter region; an aperture formed in the color filter pattern on at least one of the color filter regions; a flat protective layer at least disposed on the color filter pattern and the aperture, wherein an upper surface of a portion 410 of the flat protective layer above the color filter pattern is even with an upper surface of a portion 420 of the flat protective layer above the aperture.

In the color filter substrate according to the present embodiment, the upper surface of the portion 410 of the flat protective layer above the color filter pattern is even with the upper surface of the portion 420 of the flat protective layer above the aperture, thereby the problem that the pits cause the flat protective layer unable to be completely flat in the conventional technology can be solved.

For example, as shown in FIG. 6, the color filter substrate according to the present embodiment further comprises a columnar spacer 430 disposed above the separator 200, and an upper surface of the columnar spacer 430 is higher than an upper surface of the flat protective layer.

For example, the columnar spacer and the flat protective layer are integrally formed. When the columnar spacer and the flat protective layer are integrally formed, the columnar spacer can be firmly fixed, thus uneven display effect caused by dislocation of the columnar spacer can be prevented.

For example, the separator is a photoresist separator or a black matrix.

A third embodiment of the present invention provides a transflective liquid crystal display device. The transflective liquid crystal display device comprises an array substrate and a color filter substrate, wherein the color filter substrate is the color filter substrate according to the second embodiment of the present invention.

The transflective liquid crystal display device employs the color filter substrate according to the second embodiment, so that the cell gap of the transflective liquid crystal display device is uniform after the cell assembly process of the transflective liquid crystal display is performed. Therefore, the possibilities of grayscale deflection, reduction of reflectivity of the reflective region and other issues can be reduced.

## Claims

1. A color filter substrate of a transflective liquid crystal display, comprising:
a transparent base substrate (100);
a plurality of black matrix elements formed on a surface of the transparent base substrate (100) and separating the surface of the transparent base substrate (100) into a plurality of color filter regions;
a plurality of color filter patterns (300) arranged alternatively with the black matrix elements;
an aperture (310) formed in the color filter pattern (300) on at least one of the color filter regions within a reflective region of the transflective liquid crystal display,
wherein each color filter pattern (300) covers one color filter region except for the aperture (310) formed in the color filter pattern (300); a protective layer (410, 420) deposited on the color filter patterns (300) and the aperture (310),
wherein the upper surface of a portion of the protective layer (410) above the color filter pattern (300) is even with the upper surface of a portion of the protective layer (420) above the aperture (310),
wherein the color filter substrate further comprises a columnar spacer (430) disposed above the black matrix element, wherein, the columnar spacer (430) and the protective layer (410, 420) are integrally formed,
an entire upper surface of the protective layer (410, 420) is an even surface except for a portion on which the columnar spacer (430) is formed, and
the protective layer (410, 420) and the columnar spacer integrally formed with the protective layer are made of a photoresist.

2. The color filter substrate according to claim 1, wherein the upper surface of the columnar spacer (430) is higher than the upper surface of the protective layer (410, 420).

3. A fabrication method of a color filter substrate of a transflective liquid crystal display, comprising steps of:
forming a plurality of black matrix elements on a surface of a transparent base substrate (100), wherein the black matrix elements separate the surface of the transparent base substrate (100) into a plurality of color filter regions;
forming a plurality of color filter patterns (300) arranged alternatively with the black matrix elements; forming an aperture (310) in the color filter pattern (300) on at least one of the color filter regions within a reflective region of the transflective liquid crystal display,
wherein each color filter pattern (300) covers one color filter region except for the aperture (310) in the color filter pattern (300); forming a photoresist layer (400) covering the black matrix elements (300), the color filter patterns (300) and the aperture (310); and
performing exposing and developing processes on the photoresist layer (400) through a dual-tone mask to form a protective layer (410, 420) disposed on the color filter patterns and the aperture,
wherein the upper surface of a portion (410) of the protective layer above the color filter pattern (300) is even with the upper surface of a portion of the protective layer (420) above the aperture (310),
wherein at the same time of performing exposing and developing processes on the photoresist layer (400) through a dual-tone mask, a columnar spacer (430) disposed above the black matrix element is also formed, wherein the columnar spacer (430) and the protective layer (410, 420) are integrally formed,
an entire upper surface of the protective layer (410, 420) is an even surface except for a portion on which the columnar spacer (430) is formed,
the protective layer (410, 420) and the columnar spacer (430) are made of the photoresist layer, and
the photoresist (400) over the black matrix element is completely exposed with a complete exposure amount of A, an exposure amount for exposing the photoresist (400) over the color filter pattern (300) is H4/H3×A, and an exposure amount for exposing the photoresist (400) over the aperture (310) is (H2+H4)/H3×A, where H2 is a thickness of the color filter pattern (300), H3 is a thickness of the photoresist (400) over the black matrix element, H4 is a thickness of the portion of the protective layer (410) above the color filter pattern, and H2+H4 is a thickness of the portion of the protective layer (420) above the aperture (310).

4. The fabrication method of a color filter substrate according to claim 3, wherein the upper surface of the columnar spacer (430) is higher than the upper surface of the protective layer (410, 420).

5. A transflective liquid crystal display device, comprising the color filter substrate according to claim 1.

## Patentansprüche

1. Farbfiltersubstrat eines transflektiven Flüssigkristall-Displays, umfassend:
ein transparentes Basissubstrat (100);
eine Mehrzahl von Schwarzmatrixelementen, gebildet auf einer Oberfläche des transparenten Basissubstrates (100) und separierend die Oberfläche des transparenten Basissubstrates (100) in eine Mehrzahl von Farbfilterregionen;
eine Mehrzahl von Farbfiltermustern (300), abwechselnd mit den Schwarzmatrixelementen angeordnet;
eine Öffnung (310), gebildet in dem Farbfiltermuster (300) an zumindest einer der Farbfilterregionen innerhalb einer reflektierenden Region des transflektiven Flüssigkristall-Displays,
wobei jedes Farbfiltermuster (300) abgesehen von der in dem Farbfiltermuster (300) gebildeten Öffnung (310) eine Farbfilterregion bedeckt;
eine Schutzschicht (410, 420), aufgetragen auf den Farbfiltermustern (300) und der Öffnung (310),
wobei die obere Oberfläche eines Bereiches der Schutzschicht (410) über dem Farbfiltermuster (300) eben ist mit der oberen Oberfläche eines Bereiches der Schutzschicht (420) über der Öffnung (310),
wobei das Farbfiltersubstrat außerdem einen säulenartigen Abstandhalter (430) aufweist, der oberhalb des Schwarzmatrixelementes angeordnet ist, wobei
der säulenartige Abstandhalter (430) und die Schutzschicht (410, 420) einstückig gebildet sind,
eine gesamte obere Oberfläche der Schutzschicht 410, 420) eine ebene Oberfläche ist mit Ausnahme eines Bereiches, an welchem der säulenartige Abstandhalter (430) gebildet ist, und
die Schutzschicht (410, 420) und der säulenartige Abstandhalter, der einstückig mit der Schutzschicht gebildet ist, aus einem Photoresist hergestellt sind.

2. Farbfiltersubstrat gemäß Anspruch 1, wobei die obere Fläche des säulenartigen Abstandhalters (430) höher ist als die obere Oberfläche der Schutzschicht (410, 420).

3. Herstellungsverfahren für ein Farbfiltersubstrat eines transflektiven Flüssigkristall-Displays, umfassend die Schritte:
Bilden einer Mehrzahl von Schwarzmatrixelementen auf einer Oberfläche eines transparenten Basissubstrats (100), wobei die Schwarzmatrixelemente die Oberfläche des transparenten Basissubstrates (100) in eine Mehrzahl von Farbfilterregionen separieren;
Bilden einer Mehrzahl von Farbfiltermustern (300), die abwechselnd mit den Schwarzmatrixelementen angeordnet sind;
Bilden einer Öffnung (310) in dem Farbfiltermuster (300) an zumindest einer der Farbfilterregionen innerhalb einer reflektierenden Region des transflektiven Flüssigkristall-Displays,
wobei jedes Farbfiltermuster (300) abgesehen von der Öffnung (310) in dem Farbfiltermuster (300) eine Farbfilterregion bedeckt;
Bilden einer Photoresist-Schicht (400), die die Schwarzmatrixelemente (300), die Farbfiltermuster (300) und die Öffnung (310) bedeckt; und
Ausführen von Belichtungs- und Entwicklungsprozessen auf der Photoresist-Schicht (400) durch eine Zweitonmaske, um eine Schutzschicht (410, 420) zu bilden, die auf den Farbfiltermustern und der Öffnung aufgetragen ist,
wobei
die obere Fläche eines Bereiches (410) der Schutzschicht über dem Farbfiltermuster (300) eben ist mit der oberen Oberfläche eines Bereiches der Schutzschicht (420) über der Öffnung (310),
wobei zu der gleichen Zeit des Ausführens der Belichtungs- und Entwicklungsprozesse auf der Photoresist-Schicht (400) durch eine Zweitonmaske auch ein säulenartiger Abstandhalter (430), der oberhalb des Schwarzmatrixelementes angeordnet ist, gebildet wird,
wobei
der säulenartige Abstandhalter (430) und die Schutzschicht (410, 420) einstückig gebildet sind,
eine gesamte obere Oberfläche der Schutzschicht (410, 420) eine ebene Oberfläche ist mit Ausnahme eines Bereiches, auf dem der säulenartige Abstandhalter (430) gebildet ist,
die Schutzschicht (410, 420) und der säulenartige Abstandhalter (430) aus der Photoresist-Schicht hergestellt sind, und
das Photoresist (400) über dem Schwarzmatrixelement vollständig belichtet ist mit einem vollständigen Belichtungsbetrag von A, wobei ein Belichtungsbetrag zur Belichtung des Photoresists (400) über dem Farbfiltermuster (300) H4/H3×A beträgt, und wobei ein Belichtungsbetrag zur Belichtung des Photoresists (400) über der Öffnung (310) (H2+H4)/H3×A beträgt, wobei H2 eine Dicke des Farbfiltermusters (300) ist, H3 eine Dicke des Photoresists (400) über dem Schwarzmatrixelement ist, H4 eine Dicke des Bereiches der Schutzschicht (410) über dem Farbfiltermuster ist, und H2+H4 eine Dicke des Bereiches der Schutzschicht (420) über der Öffnung (310) ist.

4. Herstellungsverfahren eines Farbfiltersubstrates gemäß Anspruch 3, wobei die obere Oberfläche des säulenartigen Abstandhalters (430) höher ist als die obere Oberfläche der Schutzschicht (410, 420).

5. Transflektive Flüssigkristall-Display-Vorrichtung, umfassend das Farbfiltersubstrat gemäß Anspruch 1.

## Revendications

1. Un substrat de filtre coloré d'un dispositif d'affichage à cristaux liquides transflectif, comprenant :
un substrat de base transparent (100) ;
une pluralité d'éléments de matrice noire formés sur une surface du substrat de base transparent (100) et séparant la surface du substrat de base transparent (100) en une pluralité de régions de filtre coloré ;
une pluralité de motifs de filtre coloré (300) agencés alternativement avec les éléments de matrice noire ;
une ouverture (310) formée dans le motif de filtre coloré (300) sur au moins l'une des régions de filtre coloré dans une région réfléchissante du dispositif d'affichage à cristaux liquides transflectif, dans lequel chaque motif de filtre coloré (300) couvre une région de filtre coloré excepté pour l'ouverture (310) formée dans le motif de filtre coloré (300) ;
une couche protectrice (410, 420) déposée sur les motifs de filtre coloré (300) et l'ouverture (310) ,
dans lequel la surface supérieure d'une partie de la couche protectrice (410) au-dessus du motif de filtre coloré (300) est de niveau avec une surface supérieure d'une partie de la couche protectrice (420) au-dessus de l'ouverture (310),
dans lequel le substrat de filtre coloré comprend en outre une entretoise colonnaire (430) disposée au-dessus de l'élément de matrice noire,
dans lequel l'entretoise colonnaire (430) et la couche protectrice (410, 420) sont formées d'un seul tenant, une surface supérieure entière de la couche protectrice (410, 420) est une surface plane excepté pour une partie sur laquelle est formée l'entretoise colonnaire (430), et
la couche protectrice (410, 420) et l'entretoise colonnaire formée d'un seul tenant avec la couche protectrice sont faites d'une résine photosensible.

2. Le substrat de filtre coloré selon la revendication 1, dans lequel la surface supérieure de l'entretoise colonnaire (430) est plus haute que la surface supérieure de la couche protectrice (410, 420).

3. Un procédé de fabrication d'un substrat de filtre coloré d'un dispositif d'affichage à cristaux liquides transflectif, comprenant les étapes consistant à :
former une pluralité d'éléments de matrice noire sur une surface d'un substrat de base transparent (100), dans lequel les éléments de matrice noire séparent la surface du substrat de base transparent (100) en une pluralité de régions de filtre coloré;
former une pluralité de motifs de filtre coloré (300) agencés alternativement avec les éléments de matrice noire ;
former une ouverture (310) dans le motif de filtre coloré (300) sur au moins l'une des régions de filtre coloré dans une région réfléchissante du dispositif d'affichage à cristaux liquides transflectif, dans lequel chaque motif de filtre coloré (300) couvre une région de filtre coloré excepté pour l'ouverture (310) dans le motif de filtre coloré (300) ;
former une couche de résine photosensible (400) recouvrant les éléments de matrice noire (300), les motifs de filtre coloré (300) et l'ouverture (310) ; et
exécuter des processus d'exposition et de développement sur la couche de résine photosensible (400) à travers un masque à deux tons pour former une couche protectrice (410, 420) disposée sur le motif de filtre coloré et l'ouverture,
dans lequel la surface supérieure d'une partie (410) de la couche protectrice au-dessus du motif de filtre coloré (300) est de niveau avec la surface supérieure d'une partie de la couche protectrice (420) au-dessus de l'ouverture (310),
dans lequel en même temps que l'exécution des processus d'exposition et de développement sur la couche de résine photosensible (400) à travers un masque à deux tons, est également formée une entretoise colonnaire (430) disposée au-dessus de l'élément de matrice noire,
dans lequel l'entretoise colonnaire (430) et la couche protectrice (410, 420) sont formées d'un seul tenant, une surface supérieure entière de la couche protectrice (410, 420) est une surface plane excepté pour une partie sur laquelle est formée l'entretoise colonnaire (430) ,
la couche protectrice (410, 420) et l'entretoise colonnaire (430) sont faites de la couche de résine photosensible, et
la résine photosensible (400) au-dessus de l'élément de matrice noire est complètement exposée avec une quantité d'exposition complète A, une quantité d'exposition pour exposer la résine photosensible (400) au-dessus du motif de filtre coloré (300) est H4/H3xA, et une quantité d'exposition pour exposer la résine photosensible (400) au-dessus de l'ouverture (310) est (H2+H4)/H3XA, où H2 est une épaisseur du motif de filtre coloré (300), H3 est une épaisseur de la résine photosensible (400) au-dessus de l'élément de matrice noire, H4 est une épaisseur de la partie de la couche protectrice (410) au-dessus du motif de filtre coloré, et H2+H4 est une épaisseur de la partie de la couche protectrice (420) au-dessus de l'ouverture (310).

4. Le procédé de fabrication d'un substrat de filtre coloré selon la revendication 3, dans lequel la surface supérieure de l'entretoise colonnaire (430) est plus haute que la surface supérieure de la couche protectrice (410, 420).

5. Un dispositif d'affichage à cristaux liquides transflectif, comprenant le substrat de filtre coloré selon la revendication 1.
